# EUROPEAN PATENT APPLICATION

(11) **EP 0 727 819 A2**
(43) Date of publication of application: **21.08.1996**
(21) Application number: 95118784.8
(22) Date of filing: 29.11.1995
(51) Int. Cl.: H01L 25/065, H01L 25/10

(54) **Stucked arranged semiconductor device and manufacturing method for the same**

(30) Priority: 15.02.1995 JP 26533/95
(71) Applicant: MITSUBISHI DENKI KABUSHIKI KAISHA, Chiyoda-ku Tokyo (JP)
(72) Inventor: Washida, Tetsuro,, Chiyoda-ku, Tokyo 100 (JP); Ochi, Katsunori,, Chiyoda-ku, Tokyo 100 (JP)
(74) Representative: Grams, Klaus Dieter, Dipl.-Ing.

(57) **Abstract**

A semiconductor device and a manufacturing method for the same which make it possible to reduce the area required for mounting semiconductor elements. The semiconductor device is equipped with: a circuit board (1); a first electronic component (21), the area around the electrodes thereof is sealed with sealing resin (23) and which is mounted on the circuit board; and a second electronic component (41) which is disposed above the first electronic component and mounted on the circuit board.

## Description

### BACKGROUND OF THE INVENTION

### Field of the Invention:

The present invention relates to a semiconductor device with electronic components mounted thereon.

### Description of the Related Art:

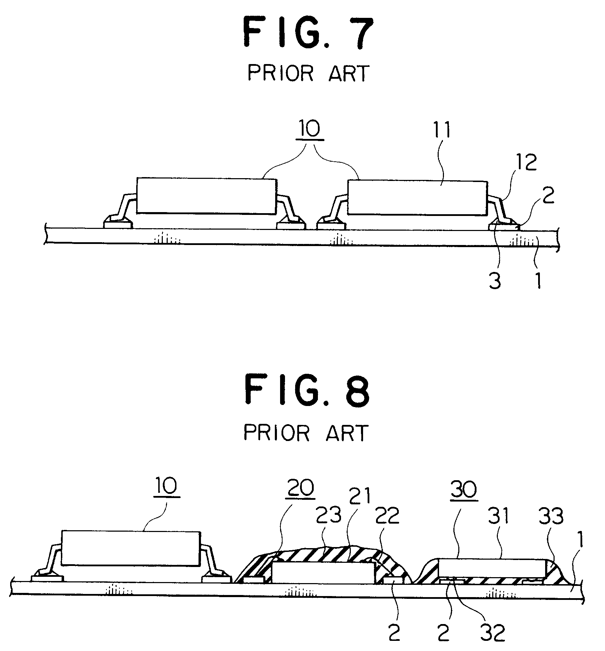

Fig. 7 is a cross-sectional view illustrative of a conventional semiconductor device. Fig. 8 is a cross-sectional view illustrative of another conventional semiconductor device. In Fig. 7, a thin small outline package (TSOP) semiconductor element 10, which is constituted by a package main body 11 produced by resin-molding a semiconductor chip and a plurality of lead terminals 12 extending from both side surfaces of the package main body 11, is mounted on a circuit board 1 by soldering the distal ends of the lead terminals 12 onto lands 2 provided on the circuit board 1.

In Fig. 8, in addition to the semiconductor element 10, a chip on board (COB) semiconductor element 20, which is produced by disposing a semiconductor element main body 21 in a predetermined position and connecting it to the predetermined lands 2 via wires 22 then by molding it with sealing resin 23, is also mounted on the circuit board 1. Further, a flip chip (FC) semiconductor element 30, which is formed by soldering a semiconductor element main body 31 having ball-shaped terminals 32 on the bottom surface thereof onto the lands 2 in predetermined positions and then molding it with sealing resin 33, is also mounted on the circuit board 1.

In such conventional semiconductor devices, to mount a plurality of semiconductor elements on the circuit board 1, it was necessary to secure a sufficient area for mounting all the semiconductor elements. The recent trend toward a larger capacity of a whole semiconductor device has led to the need of more components and according to the need for a larger area to accommodate the increased number of semiconductor elements to be mounted on the circuit board 1. There is limitation, however, in expanding the area on the circuit board 1, presenting a problem to be solved.

Thus, the conventional semiconductor devices have come to face the task of reducing the area required for mounting semiconductor elements on a circuit board to meet the need resulting from the increased capacity and more components as described above.

### SUMMARY OF THE INVENTION

The present invention has been achieved to solve the problem stated above and it is an object of the present invention to provide a semiconductor device, which requires a smaller area for mounting semiconductor elements, and a manufacturing method for the same.

To this end, according to one aspect of the present invention, there is provided a semiconductor device which is equipped with a circuit board, a first electronic component wherein sealing resin is used to seal the area around electrodes thereof and which is mounted on the circuit board, and a second electronic component which is disposed above the first electronic component and mounted on the circuit board. With this arrangement, the second electronic component is placed over the first electronic component, thus reducing the substantial area required for mounting. In addition, if the second electronic component deforms due to a pressing force applied from above, it comes in contact with the first electronic component and stops the deformation.

According to another aspect of the present invention, there is provided a semiconductor device, wherein the sealing resin is in contact with the second electronic component. With this arrangement, the second electronic component is supported by the sealing resin on the circuit board and therefore it exhibits high resistance to a pressing force applied from above.

According to still another aspect of the present invention, there is provided a semiconductor device, wherein the circuit board is equipped with a recessed section for housing the first electronic component and the first electronic component is mounted in the recessed section. With this arrangement, the first electronic component is housed in the recessed section provided in the circuit board.

According to a further aspect of the present invention, there is provided a manufacturing method for a semiconductor device, which method includes a step for mounting the first electronic component on a circuit board, a step for sealing a first electronic component with sealing resin, and a step for placing a second electronic component above the first electronic component and mounting it on the circuit board. With this arrangement, the second electronic component is placed on the first electronic component, thereby reducing the substantial area required for mounting. Furthermore, if the second electronic component deforms due to a pressing force applied from above, it comes in contact with the first electronic component and stops the deformation.

According to a still further aspect of the present invention, there is provided a manufacturing method for a semiconductor device, wherein the second electronic component is pressed against the sealing resin while the sealing resin is still soft before it is mounted on the circuit board. With this arrangement, the second electronic component is supported through its contact with the sealing resin and it provides high resistance to a pressing force applied from above.

According to another aspect of the present invention, there is provided a manufacturing method for a semiconductor device, which method includes a step for mounting the first electronic component on the circuit board, a step for placing the second electronic component above the first electronic component and mounting it on the circuit board, and a step for sealing the gap between the first electronic component and the second electronic component with sealing resin. With this arrangement, the sealing resin seals the space between the first electronic component and the second electronic component, so that the second electronic component may be fixed to the circuit board from the bottom surface.

According to still another aspect of the present invention, there is provided a manufacturing method for a semiconductor device, which method includes a step for mounting the first electronic component on the circuit board, which has a recessed section for housing the first electronic component, a step for sealing the first electronic component with sealing resin, and a step for disposing the second electronic component above the first electronic component and mounting it on the circuit board. With this arrangement, the first electronic component is housed in the recessed section provided in the circuit board.

### BRIEF DESCRIPTION OF THE DRAWINGS

Fig. 1 is a cross-sectional view illustrative of a semiconductor device which is an embodiment of the present invention;
Fig. 2 is a cross-sectional view illustrative of a semiconductor device which is another embodiment of the present invention;
Fig. 3 is a cross-sectional view illustrative of a semiconductor device which is still another embodiment of the present invention;
Fig. 4 is a cross-sectional view illustrative of a semiconductor device which is a further embodiment of the present invention;
Fig. 5 is a cross-sectional view illustrative of a semiconductor device which is a still further embodiment of the present invention;
Fig. 6 is a cross-sectional view illustrative of a semiconductor device which is yet another embodiment of the present invention;
Fig. 7 is a cross-sectional view illustrative of a conventional semiconductor device; and
Fig. 8 is a cross-sectional view illustrative of another conventional semiconductor device.

### DESCRIPTION OF THE PREFERRED EMBODIMENTS

### First Embodiment:

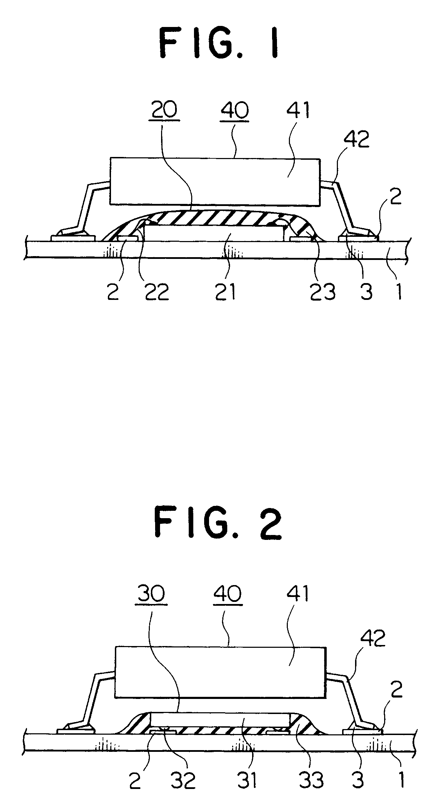

Fig. 1 is the cross-sectional view illustrative of an embodiment of the present invention. In Fig. 1, the thin COB semiconductor element 20, which is the first electronic component, is mounted in a predetermined position on the circuit board 1 provided with wiring. To mount the COB semiconductor element 20, the semiconductor element main body 21 is first fixed to the circuit board 1 with a bonding material (die bonding), the semiconductor element main body 21 is then connected to the predetermined lands 2 with the wires 22, which serve as the electrodes (wire bonding), and the semiconductor element main body 21 and the wires 22 are completely sealed with the sealing resin 23 (resin potting) to mount them. In the subsequent step, a TSOP semiconductor element 40, i.e. the second electronic component, is mounted right above the COB semiconductor element 20 in such a manner that a package main body 41 is positioned over the semiconductor element 20. To mount the TSOP semiconductor element 40, solder is supplied onto the lands 2 to which the distal ends of lead terminals 42 are connected, a plurality of the lead terminals 42 extending from both side surfaces of the package main body 41 are laid out to be placed over the COB semiconductor element 20, and the assembly is placed in a reflow furnace to melt the solder for mounting the elements. Regarding the COB semiconductor element 20 and the TSOP semiconductor element 40, the thin semiconductor element 20 and the semiconductor element 40 having the long leads 42, which allows it to be installed over the semiconductor element 20, are used in an appropriate combination.

The semiconductor device thus configured enables two semiconductor elements to be mounted in the same position on the circuit board 1. Thus, the area required for mounting the electronic components on the circuit board 1 is reduced almost to half compared with the conventional semiconductor devices, ensuring effective use of the area. Further, the space existing between the TSOP semiconductor 40 and the circuit board 1 is filled with the COB semiconductor element 20 and the sealing resin 23. Therefore, if the TSOP semiconductor element 40 is deformed due to a pressing force applied from above, it comes in contact with COB semiconductor element 20 and stops the deformation. The structure accordingly provides the semiconductor device with higher mechanical strength, leading to improved reliability of the semiconductor device.

### Second Embodiment:

Fig. 2 is the cross-sectional view illustrative of another embodiment of the present invention. In Fig. 2, an FC semiconductor element 30, i.e. the first electronic component, is mounted in a predetermined position on the circuit board 1. After a conductive adhesive or flux is printed on the bottom surface of the semiconductor element main body 31 which has ball-shaped terminals 32 formed by soldering, the FC semiconductor element 30 is mounted in the predetermined position, pressed from above the semiconductor element main body 31, heated so that the ball-shaped terminals 32 are connected to the lands 2, and sealed with the sealing resin 33. In the next step, the TSOP semiconductor element 40, i.e. the second electronic component, is mounted in such a manner that the package main body 41 is located right above the FC semiconductor element 20 as in the first embodiment.

The semiconductor device thus configured allows two electronic components to be mounted in the same position on the circuit board 1 as in the first embodiment. This reduces the area required for mounting electronic components on the circuit board 1 to about half of that required by the conventional semiconductor devices, thus permitting effective use of area.

### Third Embodiment:

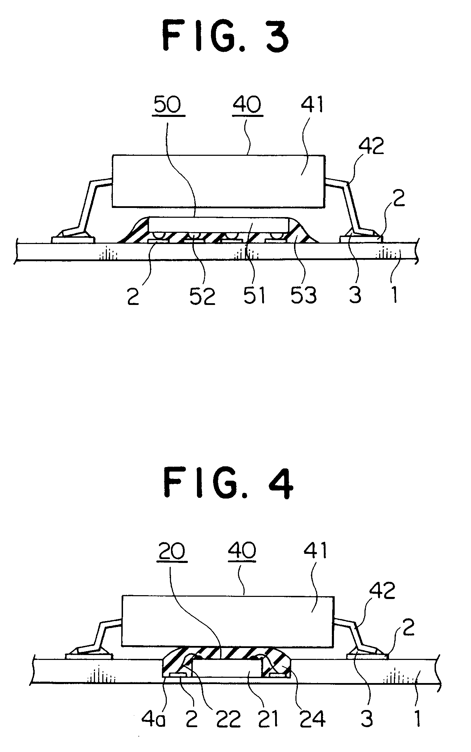

Fig. 3 is the cross-sectional view illustrative of a semiconductor device which is still another embodiment of the present invention. In Fig. 3, a thin ball grid alley (BGA) semiconductor element 50, i.e. the first electronic component, is mounted in a predetermined position on the circuit board 1. After non-isotropic conductive resin is printed on the bottom surface of a semiconductor element main body 51, which has ball-shaped terminals 52, i.e. the electrodes formed by soldering, the BGA semiconductor element 50 is mounted in a predetermined position, pressed from above the semiconductor element main body 51, heated so that the ball-shaped terminals 52 are connected to the lands 2, and sealed with the sealing resin 53. In the next step, the TSOP semiconductor element 40, i.e. the second electronic component, is mounted in such a manner that the package main body 41 is located right above the BGA semiconductor element 50 as in the first embodiment.

The semiconductor device thus configured allows two electronic components to be mounted in the same position on the circuit board 1 as in the first embodiment. This reduces the area required for mounting electronic components on the circuit board 1 to about half of that required by the conventional semiconductor devices, thus permitting effective use of area.

### Fourth Embodiment:

Fig. 4 is the cross-sectional view illustrative of the semiconductor device which is another embodiment of the present invention. In Fig. 4, a recessed section 4a for housing a semiconductor element is formed in a predetermined position of a circuit board 1 provided with wiring. The COB semiconductor element 20 is placed in the recessed section 4a. To mount the COB semiconductor element 20, the semiconductor element main body 21 is first fixed to the circuit board 1 with an adhesive (die bonding), then the wire 22 is connected to the predetermined lands (wire bonding), and the semiconductor element main body 21 and the wire 22 are completely sealed with sealing resin 24 (resin potting). In the subsequent step, solder is supplied onto the lands 2 to which the distal ends of the lead terminals 42 of the TSOP semiconductor element 40 are connected, then the TSOP semiconductor element 40 is pressed against the sealing resin 23 and placed right above the COB semiconductor element 20 while the sealing resin 23 is still soft. After that, the assembly is put in a reflow furnace to melt the solder to complete the mounting.

In the semiconductor device thus configured, since the recessed section 4a is provided in the circuit board 1, the height of the TSOP semiconductor element 40 which is mounted above the COB semiconductor element 20 is almost the same as the height of the TSOP semiconductor element which is mounted alone; therefore, the semiconductor device can be made to be nearly as thin as the conventional one. In addition, if the TSOP semiconductor element 40 is subjected to a pressing force applied from above, it is supported by the sealing resin 24, so that it is resistant to deformation caused by the pressing force applied from above. This embodiment employs the COB semiconductor which is housed and mounted in the recessed section 4a; however, the FC or BGA type semiconductor may be employed to accomplish the same configuration.

### Fifth Embodiment:

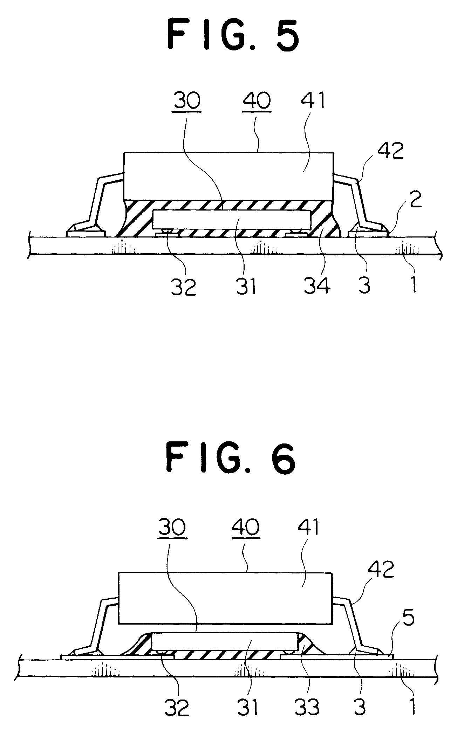

Fig. 5 is the cross-sectional view illustrative of the semiconductor device which is yet another embodiment of the present invention. In Fig. 5, the FC semiconductor element 30 is located in a predetermined position on the circuit board 1. The FC semiconductor element 30 is disposed by positioning the ball-shaped terminals 32, which have been formed by soldering on the bottom surface of the semiconductor element main body 31, onto the matching lands 2. After solder is supplied onto the matching lands 2, the TSOP semiconductor element 40, i.e. the second electronic component, is mounted above the FC semiconductor element 30 through the plurality of lead terminals 42 extending from both side surfaces of the package main body 41. After the two semiconductor elements are laid out, the circuit board 1 is put in the reflow furnace to melt the solder at the junction of the two semiconductor elements, thereby connecting both semiconductor elements to the circuit board 1. Then, sealing resin 34 is injected through the side surface, which has no lead terminal 42 of the TSOP semiconductor element 40, to seal the lower FC semiconductor element 30 and also to firmly fix the upper TSOP semiconductor element 40 on the circuit board 1.

The semiconductor device thus constructed makes it possible to melt the solder to connect the upper and lower semiconductor elements at the same time by putting them in a reflow furnace, thus achieving a reduced number of working steps. In this embodiment, the FC semiconductor element is employed as the lower semiconductor element; however, the BGA semiconductor element may alternatively be used to accomplish the same configuration. Furthermore, the upper and lower semiconductor elements, which are firmly fixed to the circuit board 1, lead to higher resistance to mechanical stress.

### Sixth Embodiment:

Fig. 6 is the cross-sectional view illustrative of a semiconductor device which is a further embodiment of the present invention. In Fig. 6, the lead terminals 42 of the TSOP semiconductor element 40, i.e. the first electronic component, and the ball-shaped terminals 32 of the FC semiconductor element 30 are connected to same lands 3. The TSOP semiconductor element 40 and the FC semiconductor element 30 share identical electrical characteristics. The rest of the configuration of the sixth embodiment is the same as the second embodiment.

In such a semiconductor device thus configured, the TSOP semiconductor element 40 and the FC semiconductor element 30 are connected to the same land 3 and electrically connected in parallel. This embodiment therefore makes it possible to mount the TSOP semiconductor element 40 and the FC semiconductor element 30, which share the same electrical characteristics, in the area where only one TSOP semiconductor element can be mounted in the conventional semiconductor devices. This doubles the electrical capacity per unit area compared with the conventional semiconductor devices.

### Seventh Embodiment:

In this embodiment, the lead terminals 42 of the TSOP semiconductor element 40, i.e. the first electronic component, and the ball-shaped terminals 32 of the FC semiconductor element 30, i.e. the second electronic component, which are described in the second embodiment, are connected to different lands. The TSOP semiconductor element 40 and the FC semiconductor element 30 have different electrical characteristics. The rest of the configuration is the same as the second embodiment.

In the semiconductor device thus configured, the TSOP semiconductor element 40 and the FC semiconductor element 30 are connected to different lands. Thus, this embodiment makes it possible to mount the TSOP semiconductor element 40 and the FC semiconductor element 30, which have different electrical characteristics, in the area where only one TSOP semiconductor element can be mounted in the conventional semiconductor devices.

### Eighth Embodiment:

In the first to seventh embodiments, the upper semiconductor element of the double tier is the TSOP semiconductor element 40. The similar configuration can be achieved, however, even when the upper semiconductor element is a small outline package (SOP) type which is an IC package with leads extending in two directions, a small outline J lead package (SOJ) type which is an IC package with the DIP leads bent inward, a quad flat package (QFP) type which is a flat package having leads in four directions, or a plastic leadless chip carrier (PLCC) type wherein the leads of the QFP type are bent inward and further to the bottom surface of the package to protect the leads from bending.

Thus, according to one aspect of the present invention, the semiconductor device is provided with the circuit board, the first electronic component wherein the area around the electrodes thereof is sealed with sealing resin and which is mounted on the circuit board, and the second electronic component which is disposed above the first electronic component and which is mounted on the circuit board. The substantial mounting area can be reduced accordingly since the second electronic component is disposed above the first electronic component, thus improving the mounting efficiency of semiconductor elements. In addition, when the second electronic component deforms due to a pressing force applied from above, it comes in contact with the first electronic component and stops the deformation. This adds to the resistance of the semiconductor device to mechanical stress and leads to higher reliability of the semiconductor device.

In the semiconductor device according to another aspect of the present invention, since the sealing resin is in contact with the second electronic component, the second electronic component is supported by the sealing resin deposited on the circuit board, providing higher resistance to a pressing force applied from above. This further improves the resistance of the semiconductor device to mechanical stress, leading to higher reliability.

In the semiconductor device according to still another aspect of the present invention, the circuit board is equipped with the recessed section to house the first electronic component and the first electronic component is mounted in the recessed section. This allows the semiconductor device to be made thinner.

The manufacturing method for a semiconductor device according to a further aspect of the present invention includes the step for mounting the first electronic component on the circuit board, the step for sealing the first electronic component with the sealing resin, and the step for disposing the second electronic component above the first electronic component to mount it on the circuit board. Thus, the second electronic component is disposed over the first electronic component to reduce the substantial mounting area, resulting in improved mounting efficiency of the semiconductor device. Moreover, when the second electronic component deforms due to a pressing force applied from above, it comes in contact with the first electronic component and stops the deformation. This increases the resistance of the semiconductor device to mechanical stress and improves the reliability of the semiconductor device.

The manufacturing method for a semiconductor device according to another aspect of the present invention is designed to mount the second electronic component on the circuit board while the sealing resin is still soft; therefore, the second electronic component is supported by the sealing resin and becomes highly resistant to a pressing force applied from above. This further adds to the mechanical stress, leading to higher reliability of the semiconductor device.

The manufacturing method according to yet another aspect of the present invention includes the step for mounting the first electronic component on the circuit board, the step for placing the second electronic component above the first electronic component and mounting it on the circuit board, and the step for sealing the gap between the first electronic component and the second electronic component with sealing resin. Thus, the sealing resin seals the space between the first electronic component and the second electronic component so that the second electronic component may be fixed to the circuit board from the bottom surface. This configuration further enhances the resistance of the semiconductor device to mechanical stress with resultant higher reliability of the semiconductor device.

The manufacturing method for a semiconductor device according to still another aspect of the present invention includes the step for mounting the first electronic component on the circuit board by placing it in the recessed section for housing the first electronic component, the step for sealing the first electronic component with sealing resin, and the step for disposing the second electronic component above the first electronic component and mounting it on the circuit board. The first electronic component is therefore housed in the recessed section provided in the circuit board, enabling a thinner semiconductor device to be fabricated.

A semiconductor device and a manufacturing method for the same which make it possible to reduce the area required for mounting semiconductor elements. The semiconductor device is equipped with: a circuit board; a first electronic component, the area around the electrodes thereof is sealed with sealing resin and which is mounted on the circuit board; and a second electronic component which is disposed above the first electronic component and mounted on the circuit board.

## Claims

1. A semiconductor device comprising:
a circuit board;
a first electronic component wherein the area around the electrodes thereof is sealed with sealing resin and which is mounted to said circuit board; and
a second electronic component which is disposed above said first electronic component and which is mounted to said circuit board.

2. A semiconductor device according to Claim 1, wherein said sealing resin is in contact with said second electronic component.

3. A semiconductor device according to Claim 1, wherein said circuit board is provided with a recessed section for housing said first electronic component and said first electronic component is installed in said recessed section.

4. A manufacturing method for a semiconductor device, comprising:
a step for mounting a first electronic component to a circuit board;
a step for sealing said first electronic component with sealing resin; and
a step for disposing the second electronic component above said first electronic component and mounting it to said circuit board.

5. A manufacturing method for the semiconductor device according to Claim 4, wherein said second electronic component is mounted to said circuit board while said sealing resin is still soft.

6. A manufacturing method for a semiconductor device, comprising:
a step for mounting a first electronic component to a circuit board;
a step for disposing a second electronic component above said first electronic component and mounting it to said circuit board; and
a step for sealing the gap between said first electronic component and said second electronic component with sealing resin.

7. A manufacturing method for a semiconductor device, comprising:
a step for mounting a first electronic component to a circuit board by housing it in a recessed section provided in said circuit board to house the first electronic component;
a step for sealing said first electronic component with sealing resin; and
a step for disposing a second electronic component above said first electronic component and mounting it to said circuit board.
